# EUROPÄISCHE PATENTSCHRIFT

(11) **EP 3 469 619 B1**
(45) Veröffentlichungstag und Bekanntmachung des Hinweises auf die Patenterteilung: **25.08.2021**
(21) Anmeldenummer: 17743302.6
(22) Anmeldetag: 18.07.2017
(51) Int. Cl.: H01H 59/00, H01H 9/54, H01H 71/00

(54) **SCHALTZELLE MIT HALBLEITERSCHALTELEMENT UND MIKROELEKTROMECHANISCHEM SCHALTELEMENT**
SWITCH CELL HAVING A SEMICONDUCTOR SWITCH ELEMENT, AND MICRO-ELECTROMECHANICAL SWITCH ELEMENT
CELLULE DE COMMUTATION COMPRENANT UN ÉLÉMENT DE COMMUTATION À SEMI-CONDUCTEUR, ET ÉLÉMENT DE COMMUTATION MICRO-ÉLECTROMÉCANIQUE

(30) Priorität: 11.08.2016 DE 102016215001
(43) Veröffentlichungstag der Anmeldung: 17.04.2019
(73) Patentinhaber: Siemens Aktiengesellschaft, 80333 München (DE)
(72) Erfinder: BAUER, Anne, 90768 Fürth (DE); SCHÖNHERR, Holger, 90537 Feucht (DE); HARTMANN, Werner, ''verstorben'' (DE)
(86) Internationale Anmeldenummer: PCT/EP2017/068075
(87) Internationale Veröffentlichungsnummer: WO 2018/028947

(56) Entgegenhaltungen:
- EP-A1- 2 337 043
- EP-A1- 2 541 568
- EP-A2- 1 930 922
- EP-A2- 2 056 315
- DE-A1- 19 850 397
- US-A1- 2007 009 202

## Beschreibung

Die Erfindung betrifft eine Schaltzelle mit einem Halbleiterschaltelement und einem mikroelektromechanischen Schaltelement nach Anspruch 1 sowie eine Schalteinheit nach Anspruch 7, einen Inverter nach Anspruch 9, ein Schaltgerät nach Anspruch 10 und ein Verfahren zum Betreiben einer Schalteinheit nach Anspruch 1. Das Dokument US2007/009202 offenbart eine Schaltzelle umfassend ein Halbleiterschaltelement, ein mikroelektromechanisches Schaltelement (MEMS), eine elektronische Ansteuerschaltung, wobei das Halbleiterschaltelement und das mikroelektromechanische Schaltelement parallel geschaltet sind und wobei die Ansteuerschaltung in der Art ausgestaltet ist, dass für einen Abschaltvorgang der Schaltzelle das Ausschalten des Halbleiterschaltelementes nach dem Ausschalten des mikroelektromechanischen Schaltelements.

Mikroelektromechanische Systeme bzw. hier konkreter mikroelektromechanische Schaltelemente, die im Weiteren als MEMS bezeichnet werden, stellen einen möglichen Ersatz für herkömmliche Leistungsschalter in der elektrischen Energieverteilung, speziell im Niederspannungsbereich dar. Da ein einzelnes Schaltelement nach der MEMS-Bauweise mikroskopische Abmessungen, typischerweise im Bereich von einigen 10 µm aufweist, ist die Spannungsfestigkeit auf einen typischen Bereich zwischen 50 - 100 V beschränkt. Für die Stromtragfähigkeit dieser MEMS gilt ebenfalls ein beschränkter Einsatzbereich von typischerweise weniger als 100mA. Dies erfordert, dass in der Praxis zur Schaltung von höheren Strömen bei dem Einsatz als Leistungsschalter eine Vielzahl dieser MEMS in einer Schaltung elektrisch parallel angeordnet sein muss. Da in der Niederspannungsschalttechnik zudem höhere Spannungen im Bereich von 700 V bis 1000 V beherrscht werden müssen, muss auch eine entsprechende Anzahl an MEMS elektrisch in Serie angeordnet sein. Aufgrund von Fertigungstoleranzen und Schwankungen im Schaltprozess, beispielsweise unterschiedliche Kontaktübergangswiderständen oder unterschiedliche Schaltzeiten wegen Kontaktklebens, herrscht zwischen den Schaltern eine unterschiedliche Spannungs- und Stromaufteilung vor. Dies wiederum führt dazu, dass manche Elemente überlastet werden können, was sich beispielsweise im Verkleben von Schaltkontakten oder im Verschmelzen bei Entstehen eines Lichtbogens äußert. Dies würde zu einer deutlichen Verringerung der zu erwartenden Lebensdauer der MEMS bzw. der Vielzahl von MEMS führen.

Die Aufgabe der Erfindung besteht darin, eine Schaltzelle bereitzustellen, die grundsätzlich für den Einsatz in einem Leistungsschalter geeignet ist und die sich gegenüber dem Stand der Technik darin auszeichnet, dass die einzelnen darin enthaltenen MEMS-Bauteile eine höhere Lebensdauer aufweisen.

Die Lösung der Aufgabe besteht in einer Schalteinheit mit den Merkmalen des Patentanspruchs 1, in einem Inverter und einem Schaltgerät mit den Merkmalen des Anspruchs 6 bzw. 7.

Unter dem Begriff MEMS ist hierbei ein Schaltelement verstanden, das mit den Mitteln der Mikrosystemtechnik hergestellt wird. Dabei wird unter dem Begriff Mikrosystemtechnik ganz allgemein die Technik verstanden, die in der Lage ist, mikroskopisch kleine mechanisch wirkende Komponenten herzustellen, beispielsweise Schalter oder Zahnräder, die dabei eine Bewegung vollziehen können. Hierbei wird in der Regel auf Technologien zurückgegriffen, die aus der Halbleiterelektronik bekannt sind, wobei auch mikroelektromechanische Schalter auf Substraten, in der Regel Silizium oder Galliumarsenid gefertigt werden können. Die Länge eines MEMS beträgt hierbei weniger als 1mm, bevorzugt weniger als 100 µm. Hierbei ist als größtes konstruktives Element eines MEMS die Schaltzunge eines Schaltelementes nach der MEMS-Bauweise verstanden.

Der Vorteil der beschriebenen Anordnung der Schaltzelle besteht darin, dass das Halbleiterschaltelementnur sehr kurzzeitig, d.h. für wenige Mikrosekunden, insbesondere weniger als 50 µs, den Strom tragen muss, um so die elektromechanischen Kontakte des MEMS, insbesondere beim Ausschaltvorgang zu entlasten. Dabei ist der Ausschaltvorgang des MEMS besonders kritisch, da beim Ausschaltvorgang Schaltplasmen wie Funken oder Lichtbögen entstehen können. Grundsätzlich ist die Umgehung der Schaltung der MEMS durch ein Halbleiterbauelement aber auch beim Einschaltvorgang sehr zweckmäßig, da beim Einschaltvorgang bei zu hohen anliegenden Strömen an dem MEMS Verschweißungen auftreten können.

Halbleiterschaltelemente sind typischerweise Transistoren, z.B. als Feldeffekttransistoren, insbesondere als besonders niederohmige, verlustarme MOSFETS (CoolFETs) ausgebildet. Andere Ausgestaltungsformen sind IGBTs und Thyristorstrukturen, jeweils in antiparalleler Ausführung um bipolaren Stromfluss insbesondere bei Wechselspannungsanwendungen zuzulassen.

Halbleiterschaltelemente können für solche kurze Zeit deutlich höher belastet werden als dies im Dauerbetrieb möglich ist. Da sie, bedingt durch eine dadurch mögliche geringere Dimensionierung, einen geringeren Platzbedarf aufweisen, können sie somit auch, wenn dies anderweitig zweckmäßig ist, direkt auf dem Siliziumchip integriert sein, auf dem auch die MEMS-Struktur dargestellt ist. Hierdurch werden Bauteilstreuungen vermieden und parasitäre Elemente, insbesondere Leitungsinduktivitäten minimiert, ferner wird der Schaltvorgang an sich optimiert. Ein solches Hybridbauteil hat einen erheblichen Vorteil gegenüber der reinen ausschließlich durch MEMS betriebenen Schaltung. Durch die beschriebene Schaltung entfallen statistische Schwankungen der Schaltzeiten beim Ein- und Ausschalten, da während dieser kritischen, aber zeitlich sehr kurzen Phase die Halbleiterschalter den Stromfluss übernehmen und somit die MEMS-Schaltkontakte strom- und spannungslos schalten. Dadurch entfallen insbesondere transiente Ungleichverteilungen von Strom und Spannungen, die ansonsten aufgrund unterschiedlicher Kontaktwiderstände und Spannungsabfälle auftreten. Insbesondere wird damit die Bildung von Schaltplasmen beim Ein- und Ausschalten unterdrückt, wodurch eine sehr viel höhere Lebensdauer für die Kontakte der MEMS erzielt werden kann. Grundsätzlich kann davon ausgegangen werden, dass die beschriebene Anordnung einen Weg eröffnet, der den großtechnischen Einsatz von MEMS in Leistungsschaltern in einer praktischen Anwendung erlaubt.

In einer Ausgestaltungsform der Erfindung ist die Ansteuerschaltung so ausgestaltet, dass sie ein Verzögerungsglied und/oder ein Impulsverlängerungsglied umfasst. Je nachdem wie die Schaltung der Ansteuerungsschaltung und deren Verbindung mit Gateelektroden des Halbleiterschaltelementes und des MEMS erfolgt, kann zur Erzielung der gewünschten Effekte des stromlosen Schaltens des MEMS entweder eine Verzögerung des Schaltvorganges des MEMS beim Einschalten bzw. eine Impulsverlängerung bei der Schaltung des Halbleiterschaltelementes beim Ausschalten zweckmäßig sein.

Grundsätzlich kann, wie bereits erwähnt, in einer zweckmäßigen Ausgestaltungsform das Halbleiterschaltelement auf demselben Substrat, insbesondere auf einem Siliziumchip angeordnet sein, auf dem auch das MEMS dargestellt ist. Hierdurch kann eine hohe Integrationsdichte erzielt werden, wobei es jedoch grundsätzlich möglich ist, das Halbleiterschaltelement auf einem separaten Chip darzustellen, der auf demselben Substrat montiert ist, wie das MEMS. Grundsätzlich kann der Halbleiterschalter jedoch auch als separate Komponente parallel geschaltet werden. Besonders vorteilhaft ist dabei die Integration der Halbleiterschaltelemente und gegebenenfalls der Gatetreiber sowohl für die MEMS-Elemente als auch für die Halbleiterschaltelemente auf dem Siliziumchip des MEMS, da bekanntermaßen das Packaging von Mikroelektronik ein wesentlicher Kosten- und Raumfaktor ist und auf die beschriebene Weise erheblich verringert werden kann. Dies ist in vergleichbarem Maße auch möglich, wenn MEMS-Chips und Treiberchips sowie Halbleiterchips auf einem gemeinsamen Substrat aufgebracht sind.

Hierbei kann es auch zweckmäßig sein, dass mehrere MEMS zu einem Array parallel und in Serie geschaltet sind und dass das Array wiederum parallel zu dem Halbleiterschaltelement geschaltet ist. Hierbei könnte ein größer dimensioniertes Halbleiterschaltelement so ausgestattet werden, dass es parallel zu einer Vielzahl von MEMS geschaltet ist, die in einem Array angeordnet sind und dabei wieder parallel und in Serie geschaltet sind. Bei einer solchen Anordnung wird weiterhin von einer Schaltzelle gesprochen. Eine Schaltzelle kann demnach auch so ausgestaltet sein, dass durch einen Halbleiterschalter mehrere MEMS, sowohl in Serienschaltung als auch in Parallelschaltung oder Kombinationen davon, bzgl. des beschriebenen Ein - und Ausschaltvorganges unterstützt werden.

Ferner ist ein Bestandteil der Erfindung eine Schalteinheit, die mehrere Schaltzellen umfasst, wobei wiederum die Schaltzellen in Serie und in der Reihe geschaltet sein können. Die Anordnung in Serien- und Reihenschaltung führt dazu, dass insgesamt ein höherer Strom bzw. eine höhere Spannung bei dem jeweiligen Schaltvorgang insgesamt anliegen kann. Für die in Niederspannungsnetzen auftretenden Spannungen und Ströme ist es daher zweckmäßig, dass eine große Anzahl von entsprechenden Schaltzellen parallel geschaltet wird, um die notwendigen Ströme, die bis zu 500 A betragen können, zu beherrschen. Zusätzlich ist zur technischen Beherrschung der Netzspannung eine Reihenschaltung von mehreren beschriebenen parallelen Anordnungen von Schaltzellen notwendig. Somit sind für eine Schalteinheit, die wiederum in einem Schaltgerät bzw. aber auch in einem Inverter gebaut sein kann, bis zu 500.000, gegebenenfalls bis zu einer Million Einzelelemente notwendig. Die jeweilige Anzahl hängt von der Art der Anwendung, von den Anforderungen, insbesondere der zu beherrschenden oder zu schaltenden Stromstärke und der anliegenden Spannung ab.

Weiterhin ist ein Bestandteil der Erfindung, sowohl ein Umrichter (Inverter) als auch ein Schaltgerät für Niederspannungs- oder Mittelspannungsnetze, die jeweils mindestens eine Schalteinheit nach einem der Ansprüche 7 oder 8 umfassen.

Ein weiterer Bestandteil der Erfindung ist ein Verfahren zum Betreiben einer Schaltzelle, wobei ein Halbleiterschaltelement und eine MEMS parallel geschaltet werden und eine elektronische Ansteuerschaltung vorgesehen ist, wobei durch die Ansteuerschaltung während eines Ausschaltvorgangs das Halbleiterschaltelement zeitlich nach dem MEMS ausgeschaltet wird.

Eine weitere vorteilhafte Ausgestaltungsform dieses Verfahrens besteht darin, dass während des Einschaltvorgangs der Schaltzelle das Halbleiterschaltelement bereits vor dem MEMS eingeschaltet wird. In beiden Fällen ergibt sich wieder der Vorteil, der bereits bzgl. der entsprechenden Vorrichtung beschrieben wird, nämlich dass das Halbleiterschaltelement während des Ausschaltens, aber auch bevorzugt während des Einschaltens zugeschaltet werden kann. Somit können während des eigentlichen Schaltvorgangs Strom- und Spannungsspitzen durch das für kurze Zeit robustere Halbleiterschaltelement abgefangen werden und das MEMS während dieses Vorgangs, also während des Einschaltens und während des Ausschaltens praktisch stromlos geschaltet wird. Somit können die Vorteile des MEMS, das über längere Zeit größere Ströme und Spannungen führen kann, ohne dabei extrem aufzuheizen, und die Vorteile des Halbleiterschaltelementes, das kurzzeitig höhere Spannungen und Ströme aufnehmen kann, ohne dabei zerstört zu werden, miteinander vereint werden und dadurch die Lebensdauer der gesamten Schaltzelle, also der Kombination des MEMS und des Halbleiterschaltelementes, vergrößert werden. Dies ermöglicht auch Anwendungen der Schaltzellen in Invertern und in Schaltgeräten für Niederspannungsnetzen.

Weitere Ausgestaltungsformen und weitere Merkmale werden anhand der folgenden Zeichnungen näher erläutert. Dabei handelt es sich um rein exemplarische Darstellungen, die keine Begrenzung des Schutzbereichs darstellen. Gleiche Merkmale, mit den gleichen Bezeichnungen und den unterschiedlichen Ausgestaltungsformen werden dabei mit denselben Bezugszeichen versehen.

Dabei zeigen:
- Figur 1:: eine stark vergrößerte Querschnittsdarstellung durch einen mikroelektromechanischen Schalter,
- Figur 2:: ein Ersatzschaltbild einer Schaltzelle mit Halbleiterschaltelement und MEMS,
- Figur 3:: eine Schaltzelle mit einer Vielzahl in Reihe und Serie geschalteter MEMS und einem Halbleiterschaltelement,
- Figur 4:: eine Schalteinheit mit mehreren parallel und in Reihe geschalteten Schaltzellen und
- Figur 5:: eine Darstellung des Stromverlaufs bezogen auf die Zeit, beim Ein- und Ausschalten einer Schaltzelle.

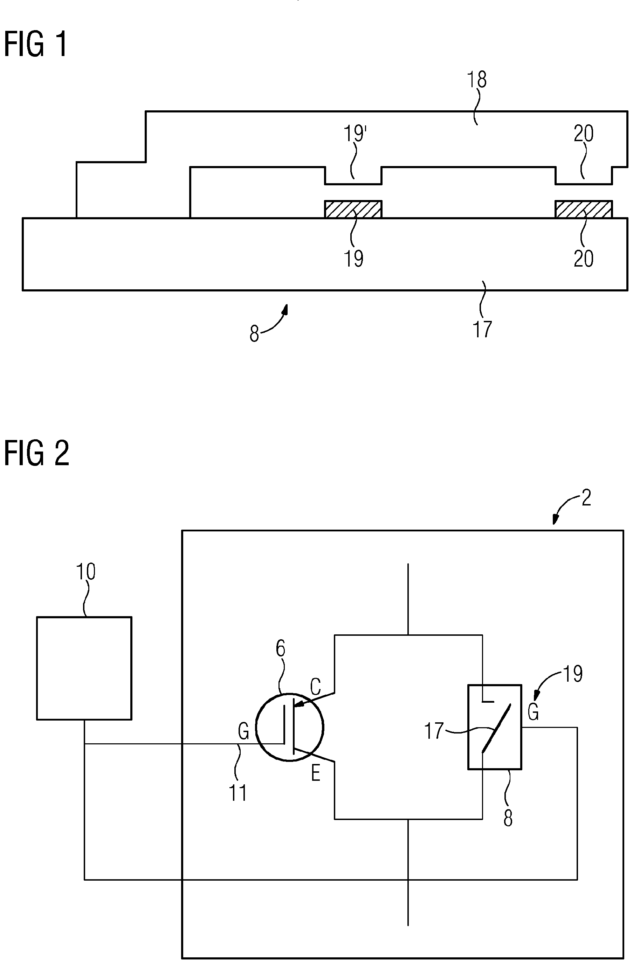

In Figur 1 ist ein mikroelektromechanisches Schaltelement, MEMS, 8 dargestellt, das auf einem Substrat 17 angeordnet ist, wobei das Substrat 17 in der Regel in Form eines Siliziumchips ausgestaltet ist. Das MEMS 8 umfasst des Weiteren eine Schaltzunge 18, die durch Verfahren der Halbleiterelektronik und der Mikrosystemtechnik aus dem Substrat 17 herausgearbeitet ist. Auf dem Substrat 17 ist eine Gateelektrode 19 vorgesehen, die entsprechend elektronisch angesteuert werden kann, der gegenüber eine Gegenelektrode 19' an der Schaltzunge 18 angeordnet ist, wobei durch Anlegen einer Spannung an der Gateelektrode 19 eine Bewegung der Schaltzunge 18 zum Substrat 17 hin hervorgerufen wird und die zwei Schaltkontakte 20 zusammengeführt werden, wodurch ein elektrischer Kontakt an den Kontakten 20 auftritt. Über die Kontakte 20 wird dann der eigentliche Stromfluss in dem MEMS geführt.

Aufbauend auf dieser allgemeinen Beschreibung eines MEMS bzgl. Figur 1 wird nun eine Schaltzelle 2 beschrieben, die ein MEMS 8 umfasst, wie es beispielhaft in Figur 1 dargestellt ist, und die ein Halbleiterschaltelement 6 umfasst, wobei das Halbleiterschaltelement 6 und das MEMS 8 parallel geschaltet sind. Ferner umfasst die Schaltzelle 2 eine elektronische Ansteuerschaltung 10, die in diesem Beispiel in Kontakt mit einer Gateelektrode 11 des Halbleiterschaltelementes 6 steht. Ferner steht die Ansteuerschaltung 10 in Verbindung mit der Gateelektrode 19 des MEMS 8.

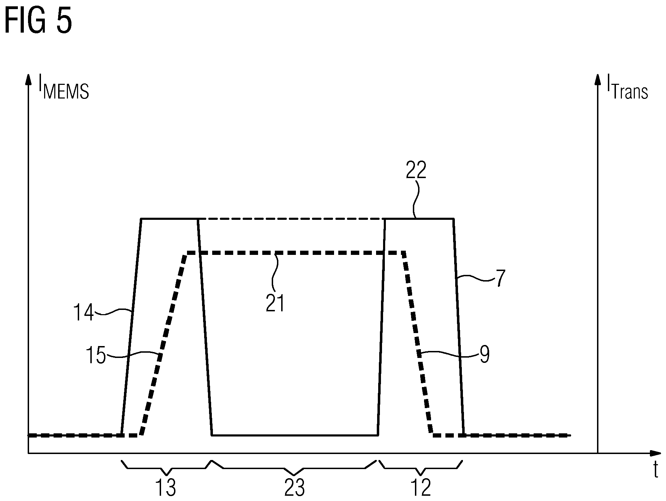

Dabei ist die Ansteuerschaltung 10 so ausgestaltet, dass bei einem Ausschaltvorgang der Schaltzelle 2 (vgl. Bezugszeichen 12 in Figur 5) das Ausschalten des Halbleiterschaltelements 6 stets erst nach dem Ausschalten des MEMS 8 erfolgt. Der Ausschaltvorgang 12 sowie auch der Einschaltvorgang 13 der Schaltzelle 2 sind in einem Strom-Zeit-Diagramm in Figur 5 veranschaulicht. Dabei weist die linke y-Achse den Stromverlauf auf, der im MEMS stattfindet und ist dort an der Achse mit I_{MEMS} bezeichnet. An der rechten y-Achse ist der Stromverlauf dargestellt, der durch das Halbleiterbauelement 6 fließt und ist mit Iₜᵣₐₙₛ gekennzeichnet. Die x-Achse zeigt den zeitlichen Verlauf. Die Kurve 21 in der Grafik nach Figur 5 bezieht sich somit auf die linke y-Achse I_{MEMS}, die Gruppe 22 bezieht sich auf die rechte y-Achse Iₜᵣₐₙₛ. In Figur 5 ist, wie bereits beschrieben, sowohl der Einschaltvorgang 13 als auch der Ausschaltvorgang 12 des Schaltelementes 2 beschrieben. Der Einschaltvorgang 13 weist dabei einen Einschaltvorgang 14 des Halbleiterbauelementes 6 und einen Einschaltvorgang 15 des MEMS 8 auf, wobei der Einschaltvorgang 15 hierbei gestrichelt dargestellt ist. Analog ist hierzu der Ausschaltvorgang 7 des Halbleiterschaltelementes 6 sowie der Ausschaltvorgang 9 des MEMS 8 dargestellt.

Es hat sich herausgestellt, dass es besonders vorteilhaft ist, wenn der Ausschaltvorgang 12 für das MEMS 8 stromlos erfolgt, da hierbei das Risiko des Auftretens von Lichtbögen besonders hoch ist und damit die Gefahr einer Beschädigung des MEMS besonders hoch ist. Daher ist die Ansteuerschaltung 10 so ausgelegt, dass während des Ausschaltvorgangs 12 vor dem Ausschalten des MEMS das Halbleiterschaltelement 6 eingeschaltet wird und der Stromfluss über dieses Halbleiterschaltelement 6 erfolgt. Während des Stromflusses über das Halbleiterschaltelement 6 wird das MEMS abgeschaltet, wobei dieses Abschalten dabei für das MEMS im Wesentlichen stromlos erfolgt, sodass dabei ein Überschlag oder eine Funkenbildung bzw. insgesamt eine Plasmabildung zwischen den Kontakten 20 vermieden wird. Die Kontakte 20 können sauber und ohne Materialabtrag voneinander getrennt werden. Erst wenn dieser Trennvorgang der Schalter 20 vonstattengegangen ist, schaltet die Ansteuerschaltung auch das Halbleiterschaltelement 6 ab, was durch den Ausschaltvorgang 7 in der Kurve 22 nach Figur 5 dargestellt ist. Dabei kann die Ansteuerschaltung ein Verzögerungselement enthalten, das mit der Gateelektrode 11 des Halbleiterschaltelementes 6 verbunden ist und dessen Ausschalten verzögert. Die Verzögerung spielt sich dabei im Mikrosekundenbereich ab, bevorzugt liegt die Verzögerung in einer Zeitspanne von weniger als 50 µs, bevorzugt weniger als 10 µs. Das gleiche vorteilhafte Verfahren ist ebenso auf den Einschaltvorgang 13 anwendbar, hier wird durch die Ansteuerschaltung das Halbleiterschaltelement so angesteuert, dass es bereits vor dem Schalten des MEMS 8 stromführend ist und der Einschaltvorgang 15 für das MEMS 8 ebenso wie der Ausschaltvorgang 9 weitgehend stromlos erfolgt. Die Schaltkurve 22, die den Stromfluss Iₜᵣₐₙₛ des Halbleiterschaltelementes 2 in Figur 5 veranschaulicht, kann zwischen dem Einschaltvorgang 13 und dem Ausschaltvorgang 12 zwei unterschiedliche Verläufe annehmen, grundsätzlich kann das Halbleiterschaltelement während der stromführenden Phase 23 des MEMS 8 abgeschaltet werden, sodass dieses Bauteil geschont wird, es kann aber grundsätzlich auch eingeschaltet bleiben, wie die gestrichelte Linie in Figur 22 veranschaulicht, da die größte stromführende Belastung aufgrund des geringeren Innenwiderstandes während des Zeitabschnittes 23 über das MEMS 8 fließt und so das Halbleiterschaltelement 6 kaum belastet wird.

Die in Figur 5 beschriebene Schaltung bzw. Stromführung der beiden parallel geschalteten Bauelemente 6 und 8 ist deshalb zweckmäßig, da einerseits das MEMS 8 und das Halbleiterschaltelement 6 bauartbedingte Vor- und Nachteile aufweisen, die sich durch die beschriebene Schaltung kompensieren. Auf der einen Seite ist das Halbleiterschaltelement dazu geeignet, kurzzeitig, also im Mikrosekundenbereich höhere Ströme zu verkraften bzw. zu schalten als die mechanisch wirkende MEMS-Struktur. Daher erfolgt der Ausschaltvorgang, aber auch bevorzugt der Einschaltvorgang durch das beschriebene Halbleiterschaltelement 6. Das Halbleiterschaltelement 6 hat allerdings den Nachteil, dass es im Dauerbetrieb zu einer starken Temperaturentwicklung kommt, was eine aufwändige Kühlung erforderlich macht. Hier kommt nun der Vorteil des MEMS 8 zum Tragen, das vergleichsweise hohe Ströme ohne größere thermische Entwicklung führen kann, da es einen niedrigeren Innenwiderstand als das Halbleiterschaltelement 6 aufweist. Dies führt wiederum dazu, dass während des Dauerbetriebs, also während der stromführenden Phase des MEMS 23 dieses mit einer geringen Wärmeentwicklung und damit einer hohen Energieeffizienz betrieben werden kann. Dabei ist anzumerken, dass der Bereich 23 in der Praxis gegenüber den Bereichen 13 und 12 um ein Vielfaches länger ist, als dies in der Figur 5 der Anschaulichkeit halber dargestellt ist.

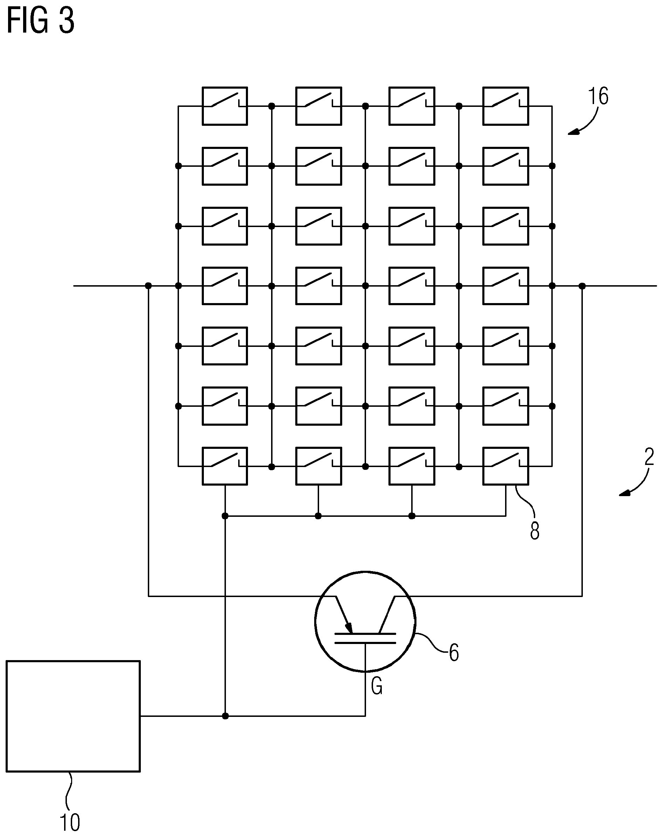

In Figur 3 ist eine Schaltzelle 2 dargestellt, die gegenüber der Schaltzelle 2 nach Figur 2 eine gewisse Veränderung aufweist. Hierbei ist ebenfalls ein Halbleiterschaltelement 6 vorgesehen, das jedoch parallel zu einer Vielzahl von MEMS 8 angeordnet ist. Hierbei bilden mehrere MEMS 8 ein Array 16, das aus einer Reihenschaltung und Serienschaltung von MEMS 8 besteht. In der Praxis ist die Anzahl der verwendeten MEMS 8 in dem Array 16 je nach Bauart sehr groß, es können mehrere hunderttausend MEMS 8 auf dem Substrat 17 angeordnet sein. Analog dazu ist auch in der Schaltzelle 2 gemäß Figur 3 eine Ansteuerschaltung 10 vorgesehen, die sowohl das Halbleiterschaltelement 6 als auch die einzelnen MEMS 8 des Arrays 16 ansteuert.

Dabei ist darauf hinzuweisen, dass das Halbleiterschaltelement einerseits als auch die Ansteuerelektronik 10 andererseits sowohl auf demselben Substrat 17 integriert bzw. angeordnet sein können. Es ist aber auch möglich, und bei einigen Ausgestaltungsformen zweckmäßig, dass das Halbleiterschaltelement und/oder die Schaltung 10, als separater Chip auf dem gemeinsamen Substrat angeordnet sind. Das ist wiederum ein entsprechender Chip, beispielsweise ein Siliziumchip oder ein Galliumarsenidchip. Je nach Leistungsklasse oder Anwendung kann auch eine Variante gewählt werden, bei der das Halbleiterschaltelement grundsätzlich entfernt von dem MEMS 8 auf einem separaten Chip angeordnet ist.

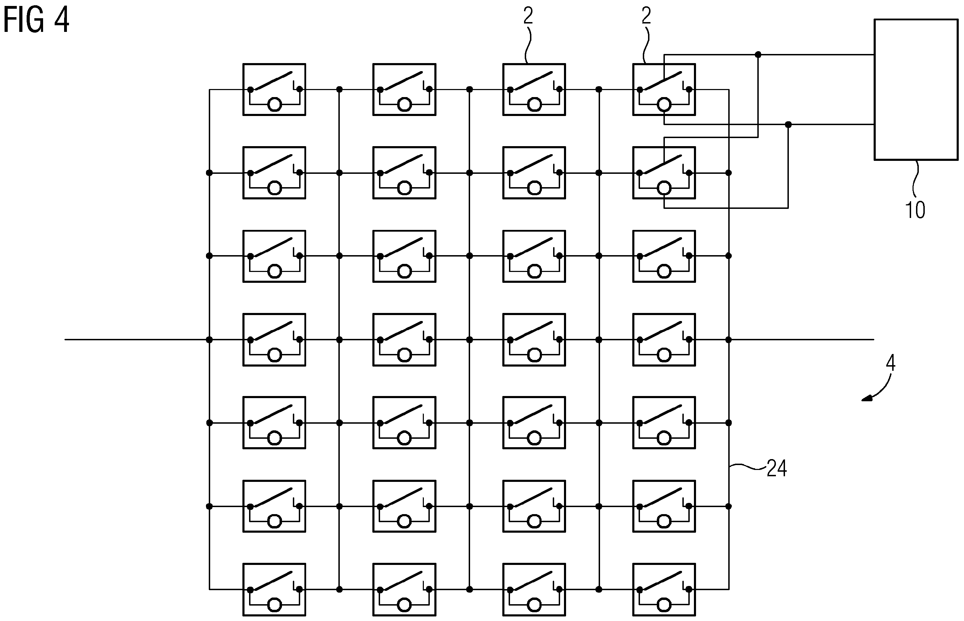

In einer weiteren Ausgestaltungsform gemäß Figur 4 ist eine Schalteinheit gezeigt, die wiederum in Form eines Arrays 24 von verschiedenen, parallel und in Serie geschalteten Schaltzellen 2 ausgestaltet ist. Auch diese einzelnen Schaltzellen 2 im Array 24 der Schalteinheit 4 können durch eine oder durch mehrere Ansteuerschaltungen 10 angesteuert werden, die wie beschrieben, entweder auf demselben Substrat oder extern montiert ist. Der Unterschied zwischen den Figuren 4 und 3 besteht darin, dass das Array 24 in Figur 4 eben einzelne Schaltzellen 2 enthält, die wiederum in Form von Schaltzellen 2 gemäß Figur 3 oder Figur 2 ausgestaltet sein können. Eine derartige Anordnung wird als Schalteinheit bezeichnet.

Eine derartige Schalteinheit 4 kann wiederum als Schalter in einem Inverter bzw. in einem Schaltgerät für Niederspannungsund Mittelspannungsnetze eingesetzt werden.

## Patentansprüche

1. Schalteinheit mit mehreren parallel geschalteten Schaltzelle umfassend ein Halbleiterschaltelement (6), mehrere mikroelektromechanische Schaltelemente (MEMS) (8), die zu einem Array parallel und in Serie geschaltet sind und das Array (16) parallel zu dem Halbleiterschaltelement (6) geschaltet ist , und eine elektronische Ansteuerschaltung (10), wobei die mikroelektromechanische Schaltelemente (8) und das Halbleiterschaltelement (6) gemeinsam auf einem Substrat integriert sind, wobei die Ansteuerschaltung (10) in der Art ausgestaltet ist, dass für einen Abschaltvorgang (12) der Schaltzelle (2) das Ausschalten des Halbleiterschaltelementes (6) nach dem Ausschalten (9) des mikroelektromechanischen Schaltelements (8) erfolgt.

2. Schalteinheit nach Anspruch 1, **dadurch gekennzeichnet, dass** für einen Einschaltvorgang (13) der Schaltzelle (2) ein Einschalten (14) des Halbleiterschaltelements vor dem Einschalten (13) des mikroelektromechanischen Schaltelements (8) erfolgt.

3. Schalteinheit nach Anspruch 1 oder 2, **dadurch gekennzeichnet, dass** die Ansteuerschaltung (10) ein Verzögerungsglied und/oder ein Impulsverlängerungsglied umfasst.

4. Schalteinheit nach Anspruch 3, **dadurch gekennzeichnet, dass** das mikroelektromechanische Schaltelement (8) und das Halbleiterschaltelement (6) gemeinsam auf einem Siliziumchip integriert sind.

5. Schalteinheit nach Anspruch 1, **dadurch gekennzeichnet, dass** mehrere Schaltzellen (2) in Reihe und parallel geschaltet sind.

6. Inverter, umfassend mindestens eine Schalteinheit (4) nach Anspruch 1.

7. Schaltgerät für Niederspannungs- oder Mittelspannungsnetze umfassend mindestens eine Schalteinheit (4) nach Anspruch 1.

## Claims

1. Switching unit comprising a plurality of switch cells connected in parallel comprising a semiconductor switch element (6), a number of micro-electromechanical switch elements (MEMS) (8), which are connected in parallel and in series to form an array, and the array (16) is connected in parallel with the semiconductor switch element (6), and an electronic actuation circuit (10), wherein the microelectromechanical switch elements (8) and the semiconductor switch element (6) are integrated jointly on a substrate, wherein for a switch-off process (12) for the switch cell (2), the actuation circuit (10) is designed such that the semiconductor switch element (6) is switched off after the micro-electromechanical switch element (8) is switched off (9).

2. Switching unit according to claim 1, **characterised in that** for a switch-on process (13) for the switch cell (2), the semiconductor switch element is switched on (14) before the micro-electromechanical switch element (8) is switched on (13) .

3. Switching unit according to claim 1 or 2 **characterised in that** the actuation circuit (10) comprises a time-delay element and/or a pulse-stretching element.

4. Switching unit according to claim 3, **characterised in that** the micro-electromechanical switch element (8) and the semiconductor switch element (6) are integrated jointly on a silicon chip.

5. Switching unit according to claim 1, **characterised in that** a plurality of switch cells (2) are connected in a row and in parallel.

6. Inverter comprising at least one switching unit (4) according to claim 1.

7. Switching device for low-voltage or medium-voltage networks comprising at least one switching unit (4) according to claim 1.

## Revendications

1. Unité de coupure ayant plusieurs cellules de coupure montées en parallèle, comprenant un élément (6) de coupure à semi-conducteur, plusieurs éléments (MEMS) de coupure micro-électromécaniques, qui sont montés en parallèle et en série en un réseau et le réseau (16) est monté en parallèle à l'élément (6) de coupure à semi-conducteur, et un circuit (10) électronique de commande, dans laquelle les éléments (8) de coupure micro-électromécaniques et l'élément (6) de coupure à semi-conducteur sont intégrés conjointement sur un substrat, dans laquelle le circuit (10) de commande est conformé de manière à produire, pour une opération (12) de déconnexion de la cellule (2) de coupure l'ouverture de l'élément (6) de coupure à semi-conducteur après l'ouverture (9) de l'élément (8) de coupure micro-électromécanique.

2. Unité de coupure suivant la revendication 1, **caractérisée en ce que**, pour une opération (13) de connexion de la cellule (2) de coupure, il se produit une fermeture (14) de l'élément de coupure à semi-conducteur avant la fermeture (13) de l'élément (8) de coupure micro-électromécanique.

3. Unité de coupure suivant la revendication 1 ou 2, **caractérisée en ce que** le circuit (10) de commande comprend un élément de temporisation et/ou un élément d'allongement de l'impulsion.

4. Unité de coupure suivant la revendication 3, **caractérisée en ce que** l'élément (8) de coupure micro-électromécanique et l'élément (6) de coupure à semi-conducteur sont intégrés conjointement sur une puce au silicium.

5. Unité de coupure suivant la revendication 1, **caractérisée en ce que** plusieurs cellules (2) de coupure sont montées en série et en parallèle.

6. Onduleur, comprenant au moins une unité (4) de coupure suivant la revendication 1.

7. Appareil de coupure pour des réseaux de basse tension ou de moyenne tension comprenant au moins une unité (4) de coupure suivant la revendication 1.
